# EUROPEAN PATENT APPLICATION

(11) **EP 4 776 311 A1**
(43) Date of publication of application: **15.07.2026**
(21) Application number: 25216119.5
(22) Date of filing: 17.11.2025
(51) Int. Cl.: H01F 17/00, H01F 41/04

(54) **PLATED MAGNETIC MATERIAL FOR COUPLED COAXIAL MAGNETIC INTEGRATED INDUCTOR**

(30) Priority: 14.01.2025 US 202519020731
(71) Applicant: INTEL Corporation, Santa Clara, CA 95054 (US)
(72) Inventor: Aleksov, Aleksandar, Chandler, AZ 85286 (US); Kandanur, Sashi S., Phoenix, AZ 85048 (US); Marin, Brandon C., Gilbert, AZ 85234 (US); Serhan, Michael Ziad, Tempe, AZ 85281 (US); Prabhu Gaunkar, Neelam, Chandler, AZ 85225 (US); Braunisch, Henning, Phoenix, AZ 85018 (US)
(74) Representative: Goddar, Heinz J.

(57) **Abstract**

Embodiments disclosed herein may include an apparatus with a substrate. In an embodiment, an opening is formed through the substrate. In an embodiment, a layer is provided over a sidewall of the opening, and the layer comprises a first magnetic material, and a plug is in the opening. In an embodiment, the plug comprises a second magnetic material that is different than the first magnetic material. In an embodiment, a first via is through the plug, and a second via may be formed through the plug.

## Description

### BACKGROUND

In semiconductor packaging applications, voltage regulators are used to improve power delivery performance. Fully integrated voltage regulators allow for higher voltages and lower currents to go through the substrate from the motherboard. This significantly reduces load line losses and improves power delivery efficiency. Inductors are a key component to the design of such voltage regulators. Currently, the inductors are included in the core of the package substrate. However, as cores continue to shrink, the inductors cannot sustain a corresponding area reduction while still maintaining the desired inductances. That is, existing integrated inductor technologies do not have the ability to scale to higher inductance densities.

### BRIEF DESCRIPTION OF THE DRAWINGS

Figures 1A is a plan view illustration of a coupled inductor in a core, in accordance with an embodiment.
Figure 1B is a cross-sectional illustration of the coupled inductor shown in Figure 1A, in accordance with an embodiment.
Figure 2A - 2K are illustrations depicting a process for forming a coupled inductor in a core, in accordance with an embodiment.
Figure 3 is a cross-sectional illustration of a pair of coaxial inductors with plated magnetic shells, in accordance with an embodiment.
Figure 4A is a plan view illustration of a coupled inductor in a core with dielectric filled vias, in accordance with an embodiment.
Figure 4B is a cross-sectional illustration of the coupled inductor shown in Figure 4A, in accordance with an embodiment.
Figures 5A - 5C are cross-sectional illustrations depicting a process for forming a coupled inductor with a dielectric filled via, in accordance with an embodiment.
Figure 6 is a flow diagram depicting a process for forming a coupled coaxial inductor, in accordance with an embodiment.
Figure 7 is a cross-sectional illustration of an electronic system with coupled coaxial inductors within a core of the package substrate, in accordance with an embodiment.
Figure 8 is a schematic of a computing device built in accordance with an embodiment.

### EMBODIMENTS OF THE PRESENT DISCLOSURE

Described herein are coupled coaxial inductor structures with a plated outer magnetic shell, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, integrated inductor structures are used for voltage regulator solutions for power delivery applications in semiconductor packages. Existing integrated inductors have taken the form of coaxial structures. For example, an electrically conductive via may be surrounded by a magnetic shell. However, such coaxial structures are limited in inductance density. Limited inductance density is problematic since the industry continues to scale to smaller package form factors. For example, the area of the package substrate may decreases, and the thickness of the core of the package substrate may decrease. This means that there is less area to place the coaxial inductor structures, and the length of the coaxial inductor structures is reduced (since the core thickness is reduced). Accordingly, it is becoming difficult to design integrated inductor structures that provide the necessary inductance for advanced packaging solutions.

Accordingly, embodiments disclosed herein may incorporate coupled coaxial inductor solutions. The coupled coaxial inductor solutions described herein allow for an additional reduction in the inductor size and/or an increased inductance while maintaining the same size. That is, embodiments described herein include an overall increase in the inductance density. The increase in inductance density is enabled, at least in part, by the use of a shared magnetic region around adjacent inductor vias. That is, a single magnetic plug may fill a cavity, and a pair of electrically conductive vias may extend through the magnetic plug. In order to further improve the inductance, a high magnetic permeability shell may be provided around the magnetic plug.

In an embodiment, the magnetic plug and the magnetic shell may include different magnetic materials. For example, the magnetic shell may be a plated magnetic material (PMM), and the magnetic plug may be a magnetic paste material (MPM). The PMM may have a higher magnetic permeability, and provides an overall increase in the inductance. The MPM is able to fill large cavities in a cost effective manner (e.g., with a squeegee filling process or the like) and is able to be patterned to form holes for the vias. The combination of the two different materials allow for the coupled inductors where the magnetic material is more efficiently utilized since a single magnetic plug can be used to surround two vias.

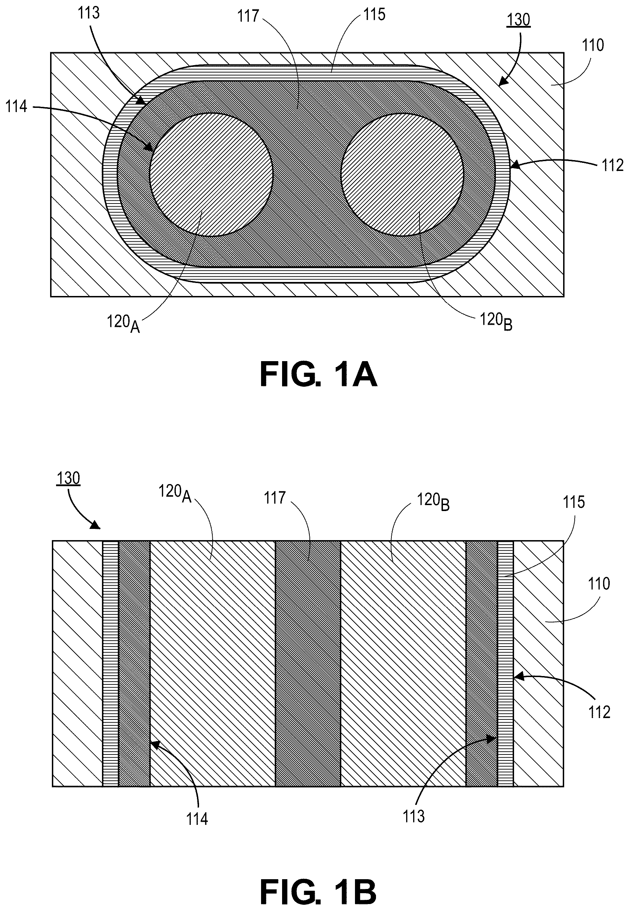

Referring now to Figures 1A and 1B, a plan view illustration (Figure 1A) and a corresponding cross-sectional illustration (Figure 1B) of a substrate 110 with an integrated coupled coaxial inductor 130 is shown, in accordance with an embodiment. In an embodiment, the substrate 110 may be a core of a package substrate. In some embodiments, the core may be an organic dielectric based material, such as a fiber reinforced dielectric material. In other embodiments, the substrate 110 may be a glass core.

In the case of a substrate with a glass core, the glass core may be substantially all glass. The glass core may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, glass core may be distinguished from, for example, the "prepreg" or "FR4" core of a Printed Circuit Board (PCB) substrate which typically comprises glass fibers embedded in a resinous organic material, such as an epoxy.

The glass core may have any suitable dimensions. In a particular embodiment, the glass core may have a thickness that is approximately 50µm or greater. For example, the thickness of the glass core may be between approximately 50µm and approximately 1.4mm. Though, smaller or larger thicknesses may also be used. The glass core may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the glass core (from an overhead plan view) may be between approximately 10mm x 10mm and approximately 250mm x 250mm. In an embodiment, the glass core may have a first side that is perpendicular or orthogonal to a second side. In a more general embodiment, the glass core may comprise a rectangular prism volume with sections (e.g., vias) removed and filled with other materials (e.g., metal, etc.).

The glass core may comprise a single monolithic layer of glass. In other embodiments, the glass core may comprise two or more discrete layers of glass that are stacked over each other. The discrete layers of glass may be provided in direct contact with each other, or the discrete layers of glass may be mechanically coupled to each other by an adhesive or the like. The discrete layers of glass in the glass core may each have a thickness less than approximately 50µm. For example, discrete layers of glass in the glass core may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The glass core may be any suitable glass formulation that has the necessary mechanical robustness and compatibility with semiconductor packaging manufacturing and assembly processes. For example, the glass core may comprise aluminosilicate glass, borosilicate glass, alumino-borosilicate glass, silica, fused silica, or the like. In some embodiments, the glass core may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, or Zn. More generally, the glass core may comprise silicon and oxygen, as well as any one or more of aluminum, boron, magnesium, calcium, barium, tin, sodium, potassium, strontium, phosphorus, zirconium, lithium, titanium, or zinc. In an embodiment, the glass core may comprise at least 23 percent silicon (by weight) and at least 26 percent oxygen (by weight). In some embodiments, the glass core may further comprise at least 5 percent aluminum (by weight).

In an embodiment, the coupled coaxial inductor 130 may be vertically oriented. That is, the coupled coaxial inductor 130 may be formed in an opening that passes from a bottom surface of the substrate 110 to a top surface of the substrate 110. The opening may have a sidewall 112. In the illustrated embodiment, the opening has an elongated shaped with rounded ends. Though, the opening may have any suitable shape. In an embodiment, the size of the opening may be chosen to allow for the formation of the coaxial inductor 130 with a desired inductance. For example, the length of the opening may be up to approximately 200µm, up to approximately 500µm, or up to approximately 1,000µm. In a particular embodiment, the length of the opening may be between approximately 200µm and approximately 500µm. In an embodiment, the coupled coaxial inductor 130 may comprise a first magnetic material and a second magnetic material, where the first magnetic material is different than the second magnetic material.

In an embodiment, the first magnetic material may be a magnetic shell 115 that is formed along the sidewall 112 of the opening through the substrate 110. The magnetic shell 115 may comprise a high magnetic permeability material. In some embodiments, the magnetic shell 115 may be a PMM. For example, the magnetic shell 115 may comprise one or more of cobalt, iron, or nickel. Additives, such as one or more of phosphorous, sulfur, oxygen, or vanadium may be added into the magnetic shell 115. In a particular embodiment, the magnetic shell 115 may comprise one or more of CoFe, CoNiFe, or CoFe:X, where X is one or more of P, S, O, or VO_{X}. The use of such a high magnetic permeability material for magnetic shell 115 allows for the overall inductance of the coupled coaxial inductor 130 to be increased while the overall size of the coupled coaxial inductor 130 is decreased or remains the same. As such, an inductance density of the coupled coaxial inductor 130 is improved over existing solutions.

In an embodiment, the thickness of the magnetic shell 115 may be any suitable thickness. Larger thicknesses provide an enhanced inductance. However, since the magnetic shell 115 is formed with a plating process, increases in the thickness of the magnetic shell 115 come at the cost of longer processing times and an increase in the manufacturing cost. In some embodiments, the magnetic shell 115 may have a thickness that is up to approximately 10µm or up to approximately 20µm. In a particular embodiment, the thickness of the magnetic shell 115 is between approximately 3µm and approximately 10µm.

In the illustrated embodiment, the magnetic shell 115 directly contacts the sidewall 112 of the opening through the substrate 110. Though, in some embodiments, the magnetic shell 115 may be separated from the substrate 110 by a seed layer. For example, the seed layer may be an electrically conductive material that is used to initiate the plating the magnetic shell 115.

In an embodiment, a magnetic plug 117 fills a portion of the opening within the magnetic shell 115. For example, the magnetic plug 117 may be surrounded by an inner sidewall 113 of the magnetic shell 115. The magnetic plug 117 comprises a magnetic material that may have a magnetic permeability that is lower than the magnetic permeability of the magnetic shell 115. The magnetic plug 117 may be an MPM. As such, the magnetic plug 117 can be dispensed into the opening through the substrate 110 rapidly and in a cost effective manner (e.g., with a squeegee process). In an embodiment, the magnetic plug 117 may be an MPM that has magnetic particles mixed into a polymer or the like.

In an embodiment, a pair of vias 120_{A} and 120_{B} are provided through a thickness of the magnetic plug 117. The vias 120_{A} and 120_{B} may be electrically conductive material, such as copper or the like. In an embodiment, the sidewalls 114 of the vias 120_{A} and 120_{B} may be surrounded by a magnetic plug 117. While the vias 120_{A} and 120_{B} are shown as being in direct contact with the magnetic plug 117, it is to be appreciated that a seed layer (not shown) may be provided between the vias 120_{A} and 120_{B} and the magnetic plug 117. In an embodiment, the vias 120_{A} and 120_{B} may have a diameter that is between approximately 25µm and approximately 200µm. In an embodiment, the sidewalls 114 of the vias 120_{A} and 120_{B} may be spaced away from the magnetic shell 115 by up to 25µm, up to 50µm, up to 100µm. Though, it is to be appreciated that any spacing may be used, depending on size constraints, desired inductance levels, and/or the like.

In the embodiment shown in Figure 1B, the sidewalls 112, 113, and 114 are all substantially vertical (i.e., orthogonal to a top and bottom surface of the substrate 110). Such vertically oriented sidewalls may be present when the opening through the substrate 110 is formed with a mechanical drilling process. Though, sidewalls with other profiles may also be present in some embodiments. For example, a laser ablation process through the substrate 110 may result in a tapered sidewall 112. In the case of a glass substrate 110, a laser assisted etching process may also provide a tapered sidewall 112 or a sidewall 112 that has a double taper (e.g., to form an opening with an hourglass shaped profile). In Figure 1B, the sidewalls 112, 113, and 114 are all substantially parallel to each other. Though, in other embodiments the sidewalls 112, 113, and 114 may not be parallel to each other. For example, the sidewall 112 may be sloped, and the sidewall 114 of the vias 120_{A} and 120_{B} may be substantially vertical. Such an embodiment may be present when a laser assisted etching process is used to form the opening through a glass substrate 110, and a mechanical drill is used to form openings through the magnetic plug 117.

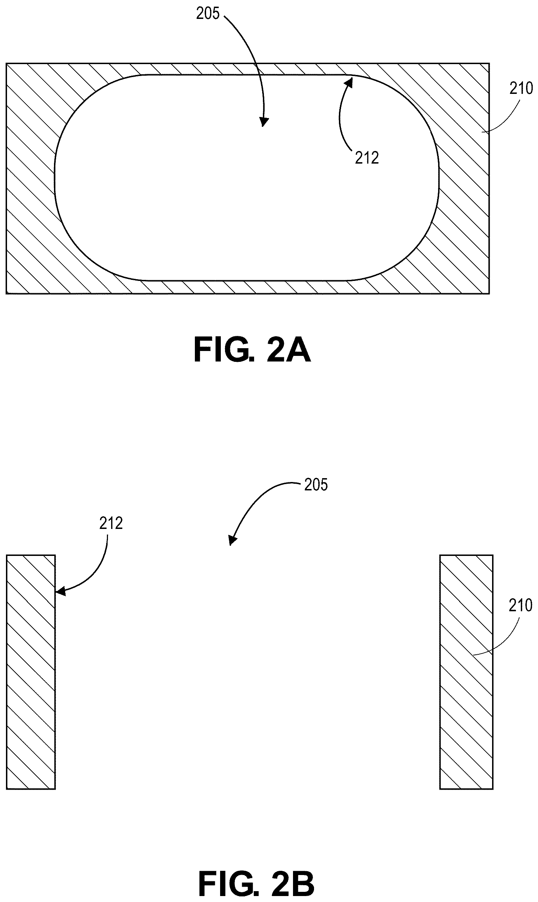

Referring now to Figures 2A - 2K, a series of illustrations depicting a process for forming an integrated coupled coaxial inductor 230 is shown, in accordance with an embodiment.

Referring now to Figures 2A and 2B, a plan view illustration (Figure 2A) and a corresponding cross-sectional illustration (Figure 2B) of a substrate 210 are shown, in accordance with an embodiment. As shown, an opening 205 is formed through a thickness of the substrate 210. In an embodiment, the substrate 210 may be a core substrate, such as an organic core, a glass core, or the like. The opening 205 may be formed with any suitable subtractive process, such as an etching process, a drilling process, a routing process, and/or the like. In the embodiment of Figures 2A and 2B, the sidewall 212 of the opening 205 is substantially vertical. Though, in other embodiments, the sidewall 212 may be sloped, curved, or the like. In an embodiment, a length of the opening 205 may be greater than a width of the opening 205. For example, a length of the opening 205 may be between approximately 200µm and approximately 500µm, and a width of the opening 205 may be between approximately 150µm and approximately 350µm. Though, it is to be appreciated that embodiments may include any suitable length and/or width for the opening 205.

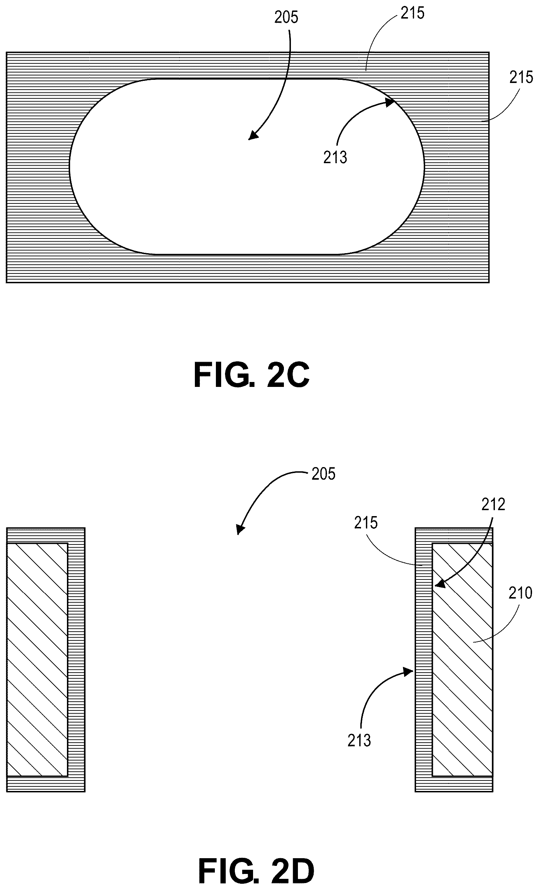

Referring now to Figures 2C and 2D, a plan view illustration (Figure 2C) and a corresponding cross-sectional illustration (Figure 2D) of the substrate 210 after a magnetic shell 215 is deposited over the substrate 210 are shown, in accordance with an embodiment. The magnetic shell 215 may be formed with any suitable plating process. For example, an electroplating process may be used to deposit the magnetic shell 215. In some embodiments, a seed layer (not shown) may be provided between the magnetic shell 215 and the substrate 210 in order to provide an initiation point for the plating process. The magnetic shell 215 may be blanket deposited over the substrate 210. For example, the magnetic shell 215 may form along the sidewall 212 of the opening 205 as well as the top surface and bottom surface of the substrate 210. An inner sidewall 213 of the magnetic shell 215 may be substantially parallel to the sidewall 212 of the opening 205.

In an embodiment, the magnetic shell 215 may comprise a PMM that has a high magnetic permeability. In an embodiment, the magnetic shell 215 may comprise any of the PMMs that have been described herein for use as the magnetic shell 215. For example, the magnetic shell 215 may comprise one or more of cobalt, iron, or nickel. Additives, such as one or more of phosphorous, sulfur, oxygen, or vanadium may be added into the magnetic shell 215. In a particular embodiment, the magnetic shell 215 may comprise one or more of CoFe, CoNiFe, or CoFe:X, where X is one or more of P, S, O, or VO_{X}.

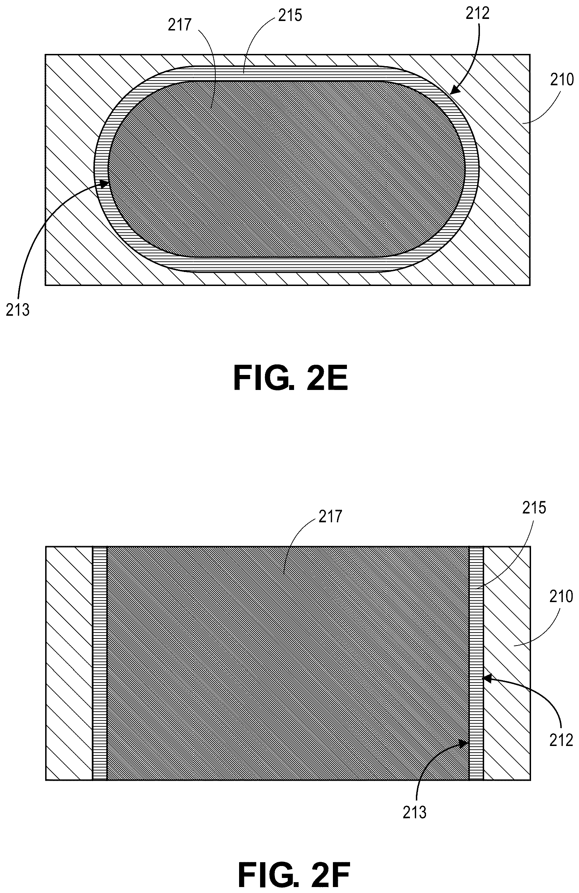

Referring now to Figures 2E and 2F, a plan view illustration (Figure 2E) and a corresponding cross-sectional illustration (Figure 2F) of the substrate 210 after a magnetic plug 217 is deposited in the opening 205 are shown, in accordance with an embodiment. In an embodiment, the magnetic plug 217 may be an MPM. In an embodiment, the magnetic plug 217 may be dispensed into the opening 205 with a squeegee fill process or the like. After the magnetic plug 217 is provided in the opening 205, portions of the magnetic shell 215 over the top and bottom surfaces of the substrate 210 are removed (e.g., with a grinding and/or polishing process).

In some embodiments, adhesion between the magnetic plug 217 and the magnetic shell 215 may be improved by roughening the inner sidewall 213 of the magnetic shell 215 prior to depositing the magnetic plug 217. For example, a short etching process may be used to roughen the inner sidewall 213 of the magnetic shell 215 in some embodiments. Since the magnetic plug 217 is deposited with a squeegee process or the like, there is no need for a seed layer. As such, the magnetic plug 217 may directly contact the magnetic shell 215.

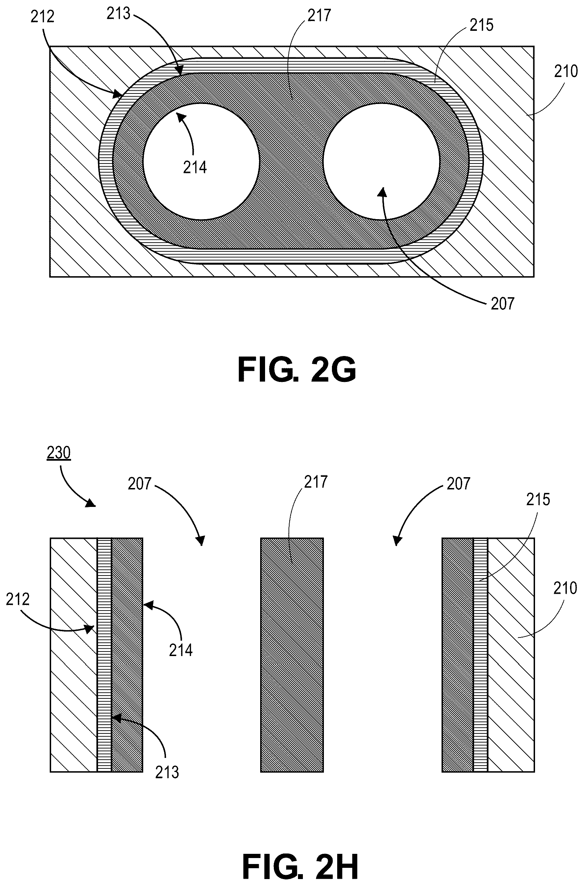

Referring now to Figures 2G and 2H, a plan view illustration (Figure 2G) and a corresponding cross-sectional illustration (Figure 2H) of the substrate 210 after openings 207 are formed through the magnetic plug 217 are shown, in accordance with an embodiment. In an embodiment, the openings 207 may be formed with a laser process, a drilling process or the like. The profile of the sidewall 214 of the openings 207 may depend on the process used to form the openings 207.

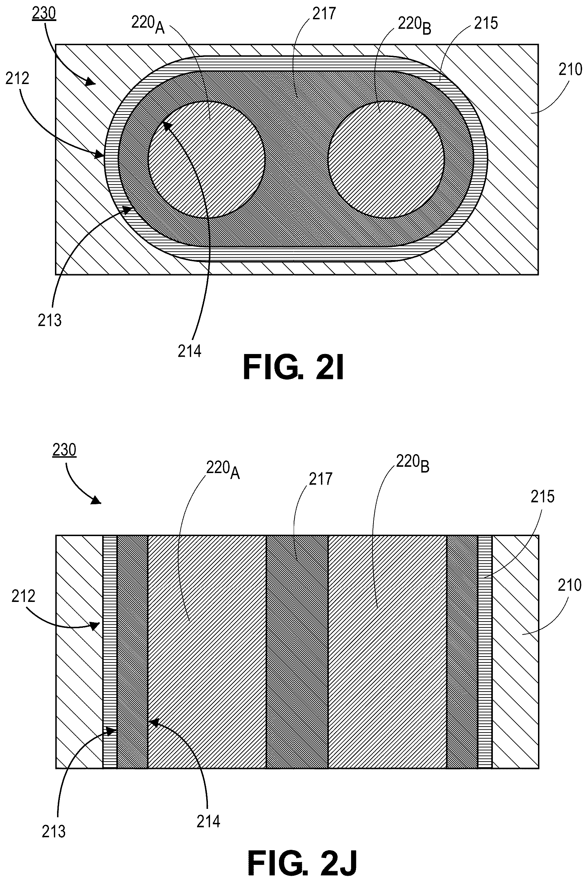

Referring now to Figures 2I and 2J, a plan view illustration (Figure 2I) and a corresponding cross-sectional illustration (Figure 2J) of the substrate 210 after vias 220_{A} and 220_{B} are formed in the openings 207 in order to complete the coupled coaxial inductor 230 are shown, in accordance with an embodiment. In an embodiment, the vias 220_{A} and 220_{B} may be plated up from the sidewall 214 of the openings 207. In some instances, a seed layer (not shown) may be provided on the sidewall 214 of the openings 207 in order to initiate the plating. That is, the vias 220_{A} and 220_{B} may be separated from the magnetic plug 217 by a seed layer material in some embodiments. A surface roughening process (e.g., a short duration etch) may be implemented on the sidewall 214 of the openings 207 in order to improve the adhesion between the vias 220_{A} and 220_{B} and the magnetic plug 217. In the illustrated embodiment, the vias 220_{A} and 220_{B} are solid. Though, in other embodiments, the vias 220_{A} and 220_{B} may be shells (as will be described in greater detail herein).

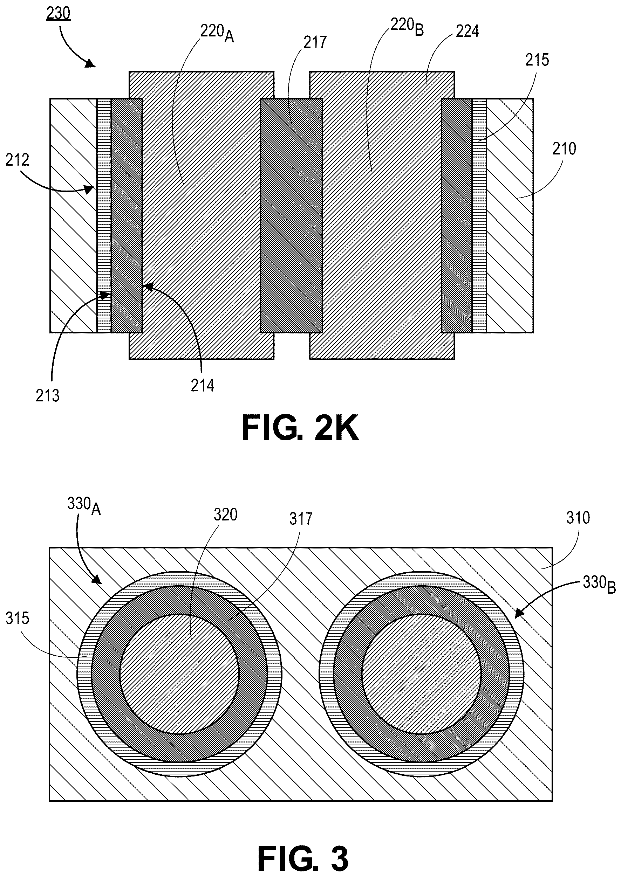

In the embodiment shown in Figures 2I and 2J, excess material (e.g., copper and/or seed layer material) is removed from the top and bottom surface of the substrate with a grinding and/or polishing process. Though, in other embodiments, a lithographically defined plating may be used to incorporate pads onto the top and bottom of the vias 220_{A} and 220_{B}. An example of such an embodiment is shown in Figure 2K. As shown, pads 224 may be provided on either end of the vias 220_{A} and 220_{B}. The pads 224 may be formed by providing a resist layer over portions of a seed layer on a top and bottom surface of the substrate 210. After plating, the resist layer and the underlying portions of the seed layer can be removed to define the pads 224 above and/or below the vias 220_{A} and 220_{B}.

Referring now to Figure 3, a plan view illustration of an alternative coaxial inductor architecture is shown, in accordance with an additional embodiment. In contrast to the coupled coaxial inductor 230 in Figures 2A - 2K, coaxial inductors 330_{A} and 330_{B} are shown in Figure 3. The coaxial inductors 330_{A} and 330_{B} may each have a single via 320 that is surrounded by a magnetic plug 317 and a magnetic shell 315 within the substrate 310. The magnetic shell 315 may be a PMM, and the magnetic plug 317 may be an MPM. Since the high magnetic permeability magnetic shell 315 is closer to the via 320, the inductance is higher than the coupled solution described above. However, since the magnetic plug 317 and the magnetic shell 315 are not shared between vias 320, the total area may be higher.

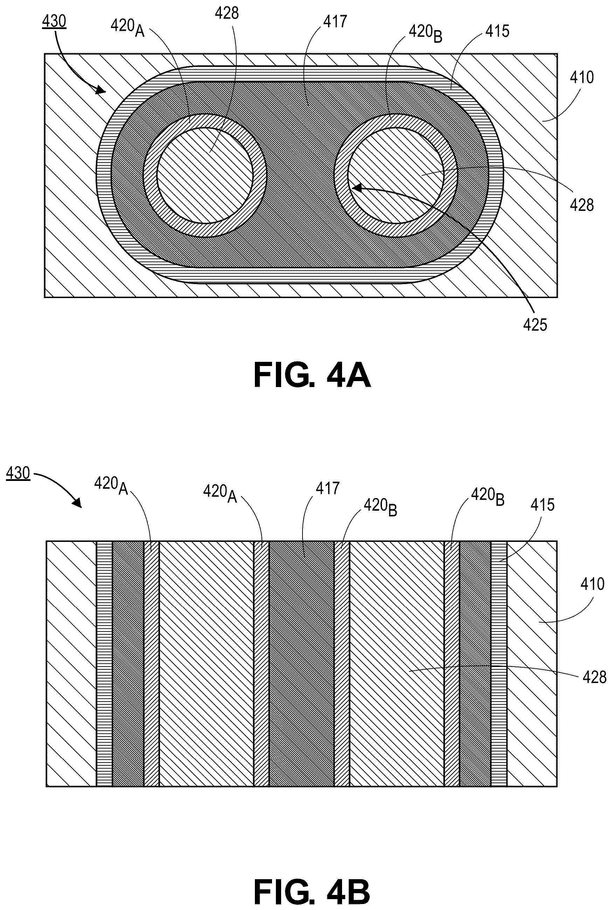

Referring now to Figures 4A and 4B, a plan view illustration (Figure 4A) and a corresponding cross-sectional illustration (Figure 4B) of a substrate 410 with an integrated coupled coaxial inductor 430 is shown, in accordance with an embodiment. In an embodiment, coupled coaxial inductor 430 may be similar to the coupled coaxial inductor 130 in Figures 1A and 1B, with the exception of the formation of the vias 420_{A} and 420_{B}. For example, the coupled coaxial inductor 430 may include a magnetic shell 415 (that is a PMM) that surrounds a magnetic plug 417 (that is an MPM). However, the vias 420_{A} and 420_{B} may be shells as well. For example, an interior of the vias 420_{A} and 420_{B} may be filled with an insulating plug material 428. That is, the insulating plug material 428 may contact an interior sidewall 425 of the vias 420_{A} and 420_{B}. The use of such a via architecture allows for faster manufacture, since the entire volume does not need to be plated with copper.

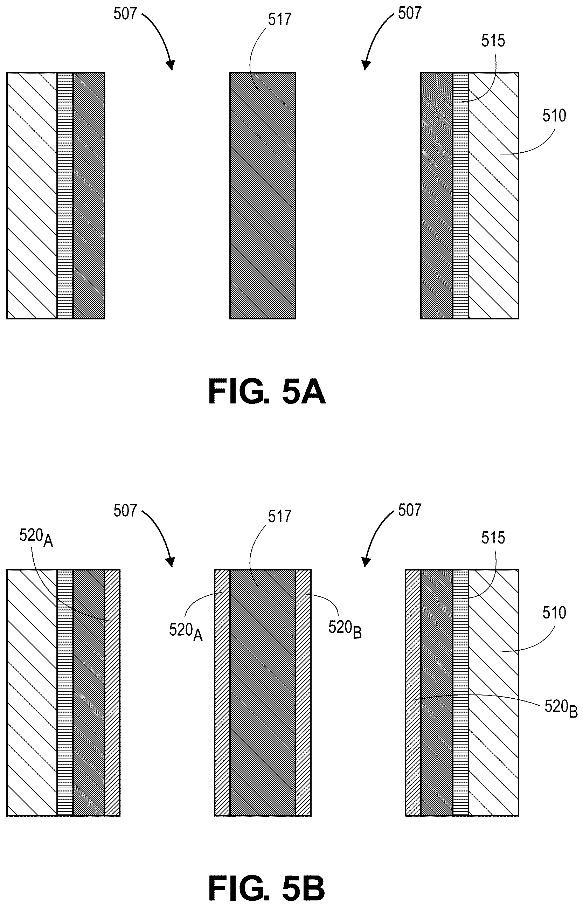

Referring now to Figures 5A - 5C, a series of cross-sectional illustrations depicting a process for forming a coupled coaxial inductor in a substrate 510 is shown, in accordance with an embodiment. In an embodiment, the structure in Figure 5A may be formed with processing operations similar to those described with respect to Figures 2A -2H. For example, a magnetic shell 515 may be formed along sidewalls of an opening through a substrate 510, and a magnetic plug 517 may fill the magnetic shell 515. Openings 507 may be formed through the magnetic plug 517 with a drilling process, a laser ablation process, or the like.

Referring now to Figure 5B, a cross-sectional illustration of the substrate 510 after via shells 520_{A} and 520_{B} are plated on the sidewalls of the openings 507 is shown, in accordance with an embodiment. In an embodiment, the sidewalls of the openings 507 may be roughened with an etching process or the like. A seed layer (not shown) may also be provided between the magnetic plug 517 and the via shells 520_{A} and 520_{B}. In an embodiment, residual seed layer material and copper over the top and bottom surface of the substrate 510 may be removed with a polishing process, an etching process, and/or the like.

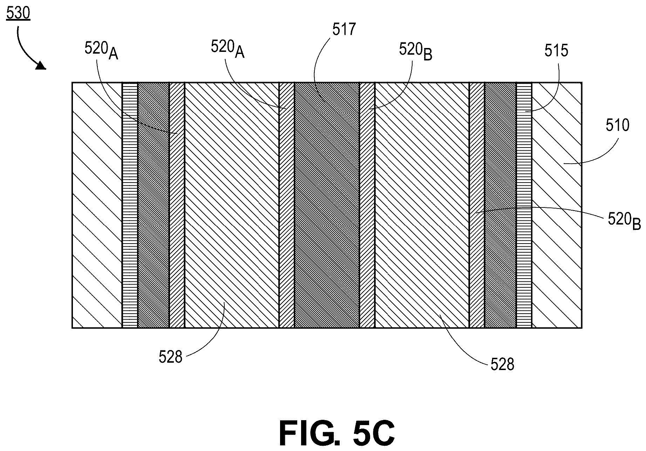

Referring now to Figure 5C, a cross-sectional illustration of the substrate 510 after an insulating plug material 528 is dispensed into the via shells 520_{A} and 520_{B} to complete the coupled coaxial conductor 530 is shown, in accordance with an embodiment. In an embodiment, the insulating plug material 528 may be any suitable filler material, such as a buildup film or the like. In an embodiment, the insulating plug material 528 may be inserted into the via shells 520_{A} and 520_{B} with any suitable process.

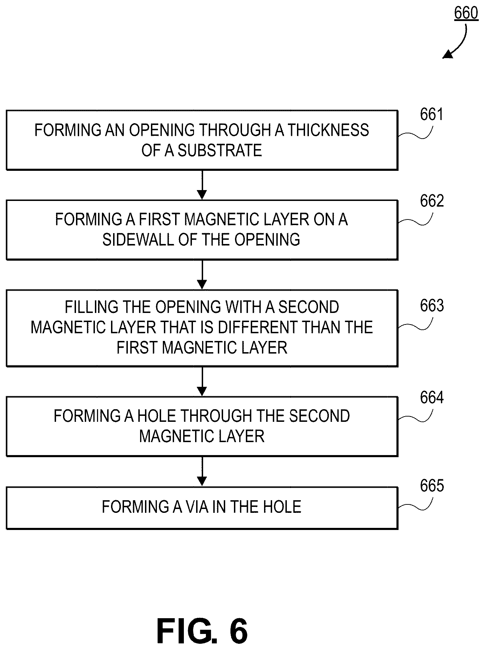

Referring now to Figure 6, a flow diagram that describes a process 660 for forming a coaxial inductor is shown, in accordance with embodiments described herein. In some instances, the process 660 may be used to form any of the integrated coupled coaxial inductors and/or integrated coaxial inductors described in greater detail herein.

In an embodiment, the process 660 may begin with operation 661, which comprises forming an opening through a thickness of a substrate. In an embodiment, the substrate may be a core of a package substrate. For example, the substrate may be an organic core, a glass core, or the like. The opening may be formed with a laser drilling process, a mechanical drilling process, an etching process, or the like.

In an embodiment, the process 660 may continue with operation 662, which comprises forming a first magnetic layer on a sidewall of the opening. In an embodiment, the first magnetic layer may comprise a PMM. The first magnetic layer may be similar in structure and/or composition to any of the magnetic shells described in greater detail herein. For example, the first magnetic layer may have a relatively high magnetic permeability. The first magnetic layer may be formed with an electroplating process, or the like.

In an embodiment, the process 660 may continue with operation 663, which comprises filling the opening with a second magnetic layer that is different than the first magnetic layer. In an embodiment, the second magnetic layer may be a MPM that is similar to any of the magnetic plugs described in greater detail herein. For example, the second magnetic layer may be dispensed in the opening with a squeegee process or the like.

In an embodiment, the process 660 may continue with operation 664, which comprises forming a hole through the second magnetic layer. In an embodiment, the hole may be formed with a drilling process, a laser ablation process, or the like. The process 660 may then continue with operation 665, which comprises forming a via in the hole. The via may be formed with a plating process. For example, a seed layer may be formed along the sidewall of the hole, and the via is plated up from the sidewall. In some embodiments, the hole is substantially filled by the via. In other embodiments, the via is a shell, and an insulating plug fills a remainder of the hole.

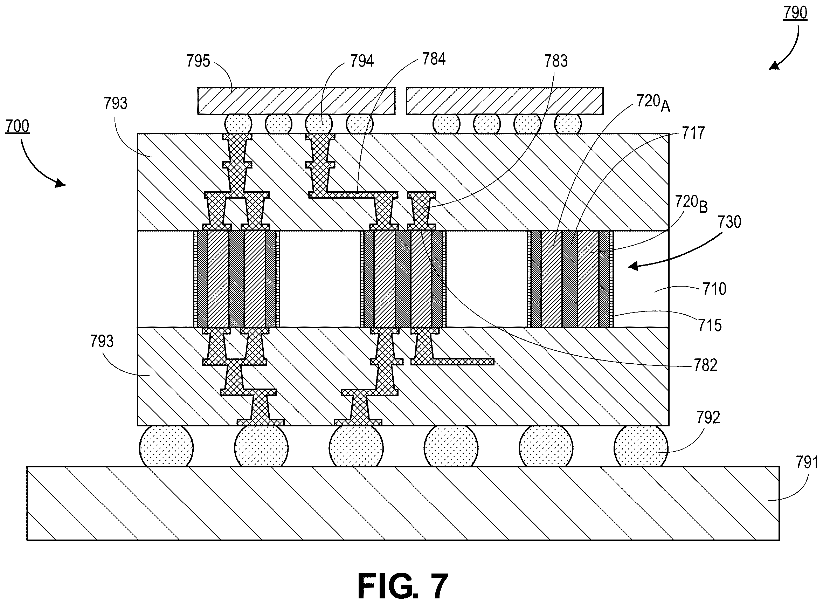

Referring now to Figure 7, a cross-sectional illustration of an electronic system 790 is shown, in accordance with an embodiment. In an embodiment, the electronic system 790 may comprise a board 791, such as a printed circuit board (PCB), a motherboard, or the like. In an embodiment, the board 791 may be coupled to a package substrate 700 by second level interconnects (SLIs) 792. In an embodiment, the SLIs 792 may comprise solder balls, sockets, or the like.

In an embodiment, the package substrate 700 may comprise a core 710 with coupled coaxial inductors 730. The coupled coaxial inductors 730 may comprise a magnetic shell 715 that is filled with a magnetic plug 717. A pair of vias 720_{A} and 720_{B} may be formed through the magnetic plug 717. In an embodiment, the magnetic shell 715 is a PMM, and the magnetic plug 717 is an MPM. For example, a magnetic permeability of the magnetic shell 715 may be higher than a magnetic permeability of the magnetic plug 717. While a particular example of the coupled coaxial inductor 730 is shown in Figure 7, it is to be appreciated that the electronic system 790 may include any of the coaxial inductor structures described herein.

In an embodiment, buildup layers 793 may be provided over and under the core 710. The buildup layers 793 may include electrical routing that electrically couples the coupled coaxial inductors 730 to other components within the electronic system 790, such as the one or more dies 795. For example, one or more of the coupled coaxial inductors 730 may be part of a voltage regulator for power delivery applications that support one or more of the dies 795. As shown in Figure 7, electrically conductive routing (e.g., pads 782, vias 783, and/or traces 784) may be used to provide an electrically conductive path from the coupled coaxial inductors 730 to one of the dies 795. In some embodiments, the coupled coaxial inductor 730 may have the first via 720_{A} and the second via 720_{B} electrically connected in parallel with each other (as shown in the leftmost coupled coaxial inductor 730 in Figure 7). Though, in other embodiments the coupled coaxial inductor 730 may have the first via 720_{A} and the second via 720_{B} provided along different electrical paths (i.e., electrically isolated from each other) as shown in the middle coupled coaxial inductor 730 in Figure 7. In addition to electrically coupling the coupled coaxial inductor 730 to one or more dies 795, the coupled coaxial inductors 730 may be electrically coupled to SLIs 792 (e.g., to provide a power delivery path from the board 791 to the coupled coaxial inductor 730).

In an embodiment, the one or more dies 795 may be coupled to the buildup layer 793 by first level interconnects (FLIs) 794. The FLIs 794 may be any suitable FLI architecture, such as solder balls, copper bumps, hybrid bonding interfaces, or the like. In an embodiment, the one or more dies 795 may be any type of die (e.g., a processor die (e.g., a central processing unit (CPU), a graphics processing unit (GPU), an XPU), a memory die, a communications die, a power management die, and/or the like). In an embodiment, two or more dies 795 may be electrically coupled together by a bridge (not shown) that is embedded in the buildup layer 793 or provided over the buildup layer 793.

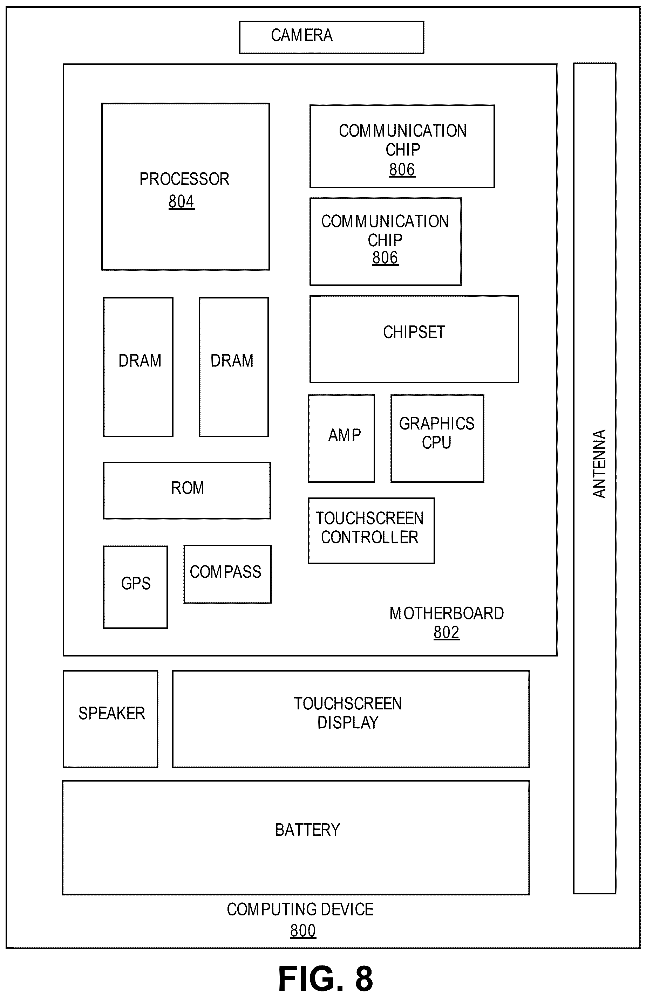

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804. In an embodiment, a device package is coupled to the board 802. One or both of the processor 804 or the communication chip 806 may be coupled to the board 802 through the device package.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the disclosure, the integrated circuit die of the processor may be part of a package substrate with a coupled coaxial inductor with a PMM shell and a MPM plug, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the disclosure, the integrated circuit die of the communication chip may be part of a package substrate with a coupled coaxial inductor with a PMM shell and a MPM plug, in accordance with embodiments described herein.

In an embodiment, the computing device 800 may be part of any apparatus. For example, the computing device may be part of a personal computer, a server, a mobile device, a tablet, an automobile, or the like. That is, the computing device 800 is not limited to being used for any particular type of system, and the computing device 800 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

### EXAMPLES:

Example 1: an apparatus, comprising: a substrate; an opening through the substrate; a layer over a sidewall of the opening, wherein the layer comprises a first magnetic material; a plug in the opening, wherein the plug comprises a second magnetic material that is different than the first magnetic material; a first via through the plug; and a second via through the plug.

Example 2: the apparatus of Example 1, further comprising: a seed layer between the sidewall of the opening and the layer.

Example 3: the apparatus of Example 1 or Example 2, wherein the first magnetic material is a plated magnetic material, and wherein the second magnetic material is a magnetic paste material.

Example 4: the apparatus of Examples 1-3, wherein the first magnetic material has a first magnetic permeability and the second magnetic material has a second magnetic permeability, and wherein the first magnetic permeability is higher than the second magnetic permeability.

Example 5: the apparatus of Examples 1-4, wherein the first magnetic material comprises one or more of cobalt, iron, or nickel.

Example 6: the apparatus of Example 5, wherein the first magnetic material further comprises one or more of phosphorous, sulfur, oxygen, or vanadium.

Example 7: the apparatus of Examples 1-6, wherein the layer has a thickness up to 10µm.

Example 8: the apparatus of Examples 1-7, wherein the first via is spaced apart from the second via by a portion of the plug.

Example 9: the apparatus of Examples 1-8, wherein the first via is a shell, and wherein the shell is filled with an electrically insulating layer.

Example 10: the apparatus of Examples 1-9, further comprising: a first seed layer between the plug and the first via; and a second seed layer between the plug and the second via.

Example 11: an apparatus, comprising: a substrate; an inductor through a thickness of the substrate, wherein the inductor comprises: a first via that is electrically conductive; a second via that is electrically conductive; a plug around the first via and the second via, wherein the plug comprises a first magnetic material; and a shell around the plug, wherein the shell comprises a second magnetic material that is different than the first magnetic material, and wherein the plug directly contacts the shell.

Example 12: the apparatus of Example 11, wherein the first magnetic material is a magnetic paste material, and wherein the second magnetic material is a plated magnetic material.

Example 13: the apparatus of Example 11 or Example 12, wherein the first magnetic material has a first magnetic permeability and the second magnetic material has a second magnetic permeability, and wherein the first magnetic permeability is lower than the second magnetic permeability.

Example 14: the apparatus of Examples 11-13, wherein the first magnetic material comprises one or more of cobalt, iron, or nickel.

Example 15: the apparatus of Example 14, wherein the first magnetic material further comprises phosphorous, sulfur, oxygen, or vanadium.

Example 16: the apparatus of Examples 11-15, wherein the substrate comprises an organic dielectric material.

Example 17: the apparatus of Examples 11-16, wherein the substrate comprises a glass layer.

Example 18: an apparatus, comprising: a substrate; an opening through a thickness of the substrate; a shell that lines a sidewall of the opening, wherein the shell comprises a first magnetic material that comprises one or more of cobalt, iron, or nickel; a plug within the shell, wherein the plug comprises a second magnetic material comprises a polymer with magnetic filler particles; and a via through the plug, wherein the via is electrically conductive.

Example 19: the apparatus of Example 18, wherein the via has an electrically insulating core.

Example 20: the apparatus of Example 18 or Example 19, further comprising: a seed layer between the shell and the sidewall of the opening, and wherein the plug directly contacts the shell.

## Claims

1. An apparatus, comprising:
a substrate;
an opening through the substrate;
a layer over a sidewall of the opening, wherein the layer comprises a first magnetic material;
a plug in the opening, wherein the plug comprises a second magnetic material that is different than the first magnetic material;
a first via through the plug; and
a second via through the plug.

2. The apparatus of claim 1, further comprising:
a seed layer between the sidewall of the opening and the layer.

3. The apparatus of claim 1 or 2, wherein the first magnetic material is a plated magnetic material, and wherein the second magnetic material is a magnetic paste material.

4. The apparatus of claim 1, 2 or 3, wherein the first magnetic material has a first magnetic permeability and the second magnetic material has a second magnetic permeability, and wherein the first magnetic permeability is higher than the second magnetic permeability.

5. The apparatus of claim 1, 2, 3 or 4, wherein the first magnetic material comprises one or more of cobalt, iron, or nickel.

6. The apparatus of claim 5, wherein the first magnetic material further comprises one or more of phosphorous, sulfur, oxygen, or vanadium.

7. The apparatus of claim 1, 2, 3, 4, 5 or 6, wherein the layer has a thickness up to 10µm.

8. The apparatus of claim 1, 2, 3, 4, 5, 6 or 7, wherein the first via is spaced apart from the second via by a portion of the plug.

9. The apparatus of claim 1, 2, 3, 4, 5, 6, 7 or 8, wherein the first via is a shell, and wherein the shell is filled with an electrically insulating layer.

10. The apparatus of claim 1, 2, 3, 4, 5, 6, 7, 8 or 9, further comprising:
a first seed layer between the plug and the first via; and
a second seed layer between the plug and the second via.

11. A method of fabricating an apparatus, the method comprising:
providing a substrate;
forming an opening through the substrate;
forming a layer over a sidewall of the opening, wherein the layer comprises a first magnetic material;
forming a plug in the opening, wherein the plug comprises a second magnetic material that is different than the first magnetic material;
forming a first via through the plug; and
forming a second via through the plug.

12. The method of claim 11, further comprising:
forming a seed layer between the sidewall of the opening and the layer.

13. The method of claim 11 or 12, wherein the first magnetic material is a plated magnetic material, and wherein the second magnetic material is a magnetic paste material.

14. The method of claim 11, 12 or 13, wherein the first magnetic material has a first magnetic permeability and the second magnetic material has a second magnetic permeability, and wherein the first magnetic permeability is higher than the second magnetic permeability.

15. The method of claim 11, 12, 13 or 14, wherein the first magnetic material comprises one or more of cobalt, iron, or nickel.
